# EUROPÄISCHE PATENTSCHRIFT

(11) **EP 4 186 157 B1**
(45) Veröffentlichungstag und Bekanntmachung des Hinweises auf die Patenterteilung: **12.06.2024**
(21) Anmeldenummer: 21769393.6
(22) Anmeldetag: 25.08.2021
(51) Int. Cl.: H02P 9/14, H02P 21/00, H02P 21/14, H02P 21/32, G01R 27/08

(54) **PARAMETERIDENTIFIKATIONSVERFAHREN FÜR DREHFELDMASCHINEN UND REGELVORRICHTUNG DAMIT**
PARAMETER IDENTIFICATION METHOD FOR AC MACHINES AND CONTROL DEVICE USING THE SAME
PROCÉDÉ D'IDENTIFICATION DE PARAMÈTRES POUR MACHINES À CHAMP TOURNANT ET DISPOSITIF DE RÉGULATION L'UTILISANT

(30) Priorität: 30.09.2020 EP 20199139
(43) Veröffentlichungstag der Anmeldung: 31.05.2023
(73) Patentinhaber: Innomotics GmbH, 90441 Nürnberg (DE)
(72) Erfinder: GIESSLER, Folke, 96170 Lisberg (DE); LEHMEIER, Mathias, 92318 Neumarkt (DE); STARK, Peter, 95448 Bayreuth (DE); WIECHMANN, Harald, 96114 Hirschaid (DE)
(74) Vertreter: Siemens Patent Attorneys
(86) Internationale Anmeldenummer: PCT/EP2021/073498
(87) Internationale Veröffentlichungsnummer: WO 2022/069114

(56) Entgegenhaltungen:
- EP-A1- 2 421 146
- HASNI M. ET AL: "Synchronous machine parameter identification in frequency and time domain", SERBIAN JOURNALOF ELECTRICAL ENGINEERING , Bd. 4, Nr. 1 1. Januar 2007 (2007-01-01), Seiten 51-69, XP055775847, YU ISSN: 1451-4869, DOI: 10.2298/SJEE0701051H Gefunden im Internet: URL:http://www.journal.ftn.kg.ac.rs/Vol_4- 1/05-Hasni-Djema-Touhami-Ibtiouen-Fadel-Ca ux.pdf [gefunden am 2021-02-15]
- BENN L C ET AL: "PWM spectrum analysis and optimization for model based condition monitoring and control", CONFERENCE RECORD OF THE 2001 IEEE INDUSTRY APPLICATIONS CONFERENCE. 36TH IAS ANNUAL MEETING . CHICAGO, IL, SEPT. 30 - OCT. 4, 2001; [CONFERENCE RECORD OF THE IEEE INDUSTRY APPLICATIONS CONFERENCE. IAS ANNUAL MEETING], NEW YORK, NY : IEEE, US, 30. September 2001 (2001-09-30), Seite 1311, XP032142896, DOI: 10.1109/IAS.2001.955686 ISBN: 978-0-7803-7114-9
- PACAS M ET AL: "Identification of the mechanical system of a drive in the frequency domain", IECON 2004 - 30TH ANNUAL CONFERENCE OF IEEE INDUSTRIAL ELECTRONICS SOCIETY (IEEE CAT. NO.04CH37609)2004IEEEPISCATAWAY, NJ, USA, PISCATAWAY, NJ : IEEE SERVICE CENTER, US, Bd. 2, 2. November 2004 (2004-11-02), Seiten 1166-1171, XP010798967, DOI: 10.1109/IECON.2004.1431740 ISBN: 978-0-7803-8730-0

## Beschreibung

### Parameteridentifikation für Drehfeldmaschinen

Die Erfindung betrifft ein Verfahren zur Bestimmung von Regelparametern zur Regelung eines elektrischen Antriebs mittels einer Vektorregelung, wobei der elektrische Antrieb mindestens eine elektrische Maschine aufweist. Ferner betrifft die Erfindung eine Regelvorrichtung für einen elektrischen Antrieb mittels Vektorregelung sowie einen elektrischen Antrieb mit einer derartigen Regelvorrichtung, einem Frequenzumrichter und einer elektrischen Maschine.

Ein elektrischer Antrieb weist oftmals zumindest einen Frequenzumrichter und eine elektrische Maschine auf. Dabei steuert oder regelt der Frequenzumrichter die elektrische Maschine. Für die Regelung gibt es verschiedene mathematische Ansätze. Ein Ansatz ist die Vektorregelung. Zur Parametrierung der Vektorregelung des Frequenzumrichters werden dabei Parameter der elektrischen Maschine benötigt, die sich oftmals aus der physikalischen Beschreibung, Nachbildung oder Modellierung der elektrischen Maschine ergeben. Die benötigten Daten liegen dabei als Ersatzschaltbilddaten häufig gar nicht, unvollständig oder fehlerhaft vor. Die für die Regelung benötigten Parameter werden auch als Regelparameter bezeichnet. Derzeit werden die Parameter der elektrischen Maschine, auch als Motorparameter bezeichnet, während der Inbetriebsetzung teilweise sehr zeitaufwendig durch unterschiedliche Herangehensweise und Versuche ermittelt.

Das Dokument HASNI M. ET AL: "Synchronous machine parameter identification in frequency and time domain", SERBIAN JOURNALOF ELECTRICAL ENGINEERING, Bd. 4, Nr. 11. Januar 2007 (2007-01-01), Seiten 51-69, ISSN: 1451-4869, DOI: 10.2298/SJEE0701051H offenbart Synchronmaschineparameteridentifikation im Frequenz- und Zeitbereich.

Die EP 2 421 146 A1 offenbart ein Verfahren zur drehgeberlosen Identifikation magnetomechanischer Kenngrößen, insbesondere Massenträgheitsmoment J und Permanentmagnetfluss zwischen Rotor und Stator eines Drehstrom-Synchronmotors.

Das Dokument BENN L C ET AL: "PWM spectrum analysis and optimization for model based condition monitoring and control", CONFERENCE RECORD OF THE 2001 IEEE INDUSTRY APPLICATIONS CONFERENCE. 36TH IAS ANNUAL MEETING . CHICAGO, IL, SEPT. 30 - OCT. 4, 2001; [CONFERENCE RECORD OF THE IEEE INDUSTRY APPLICATIONS CONFERENCE. IAS ANNUAL MEETING], NEW YORK, NY : IEEE, US, 30. September 2001 (2001-09-30), Seite 1311, DOI: 10.1109/IAS.2001.955686, ISBN: 978-0-7803-7114-9 offenbart eine PWM-Spektrumanalyse und - Optimierung für modellbasierte Zustandsüberwachung und -steuerung unter Verwendung von PRBS mit Schieberegistern.

Der Erfindung liegt die Aufgabe zugrunde, die Inbetriebsetzung des elektrischen Antriebs zu verbessern.

Diese Aufgabe wird durch ein Verfahren zur Bestimmung von Regelparametern zur Regelung eines elektrischen Antriebs mittels einer Vektorregelung gelöst, wobei der elektrische Antrieb mindestens eine elektrische Maschine aufweist, wobei an dreiphasigen Wicklungsanschlüssen der elektrischen Maschine als Signal ein Stromzeiger angelegt wird, wobei jeweils eine d-Komponente und eine q-Komponente einer Statorspannung und eines Statorstroms an den Wicklungsanschlüssen gemessen wird, wobei in einem ersten Messschritt ein rotierender Stromzeiger an die dreiphasigen Wicklungsanschlüssen angelegt wird und die elektrische Maschine derart ausgerichtet wird, dass ein Erregerstrom in der q-Achse ein Minimum annimmt, wobei in einem zweiten Messschritt bei feststehendem Rotor der elektrischen Maschine eine Feldwicklung der elektrischen Maschine kurzgeschlossen und an die dreiphasigen Wicklungsanschlüsse ein Stromzeiger in Form eines binären Rauschsignals angelegt wird, wobei aus der gemessenen d-Komponente und der q-Komponente der Statorspannung und des Statorstroms eine Statorimpedanz als ein erster Regelparameter bestimmt wird. Ferner wird diese Aufgabe durch eine Regelvorrichtung für einen elektrischen Antrieb zur Durchführung einer Vektorregelung gelöst, wobei die Regelvorrichtung zur Durchführung eines derartigen Verfahrens eingerichtet ist, wobei mittels der Regelvorrichtung in einer Inbetriebsetzungsphase mindestens ein Regelparameter für die Vektorregelung bestimmbar und speicherbar ist, wobei nach Abschluss der Inbetriebsetzungsphase mindestens ein gespeicherter Regelparameter für die Vektorregelung verwendbar ist. Diese Aufgabe wird weiter durch einen elektrischen Antrieb, aufweisend einen Frequenzumrichter und mindestens eine elektrische Maschine gelöst, wobei der Frequenzumrichter eine derartige Regelvorrichtung aufweist, wobei eine Spannungsmessvorrichtung und eine Strommessvorrichtung in der elektrischen Verbindung zwischen Frequenzumrichter und elektrischer Maschine angeordnet sind.

Weitere vorteilhafte Ausgestaltungen der Erfindung sind in den abhängigen Ansprüchen angegeben.

Der Erfindung liegt unter anderem die Erkenntnis zugrunde, dass sich die Inbetriebnahme dadurch verbessern lässt, dass sich in einer Stillstandsmessung beispielsweise mittels der Regelvorrichtung, die Impedanzen in der d-Achse und der q-Achse der elektrischen Maschine ermitteln lassen. Im Folgenden wird die elektrische Maschine auch als Motor bezeichnet. Dazu wird der Rotor der elektrischen Maschine zuerst ausgerichtet und dann festgehalten. Durch die Beaufschlagung der elektrischen Motoranschlüsse mit einem binären Rauschsignal werden dann Statorströme und Statorspannungen an den Anschlussklemmen des Motors gemessen. Mit einem numerischen Verfahren, wie beispielsweise nach Gauß oder Newton werden dann die benötigten Ersatzschaltbilddaten ermittelt. Da diese entsprechenden Werte als Parameter für die Regelung, insbesondere für die Vektorregelung, benötigt werden, werden diese Werte auch als Regelparameter bezeichnet. Diese können unabhängig von der Frequenz der Regelung zur Verfügung gestellt werden oder auch in Abhängigkeit von der Frequenz als sogenannter Frequenzgang ermittelt werden. Durch die Verwendung des Frequenzgangs als Regelparameter kann das Verhalten der Regelung in einzelnen Arbeitspunkten optimiert werden. Gerade beim Vorhandensein von Resonanzstellen kann die Regelung stabilisiert werden und Rückwirkungen auf die Last oder das Energieversorgungsnetz reduziert werden.

Die Messung kann dabei von einer Messvorrichtung, auch als Messbox bezeichnet, durchgeführt werden. Diese Messbox kann mit vergleichsweise niedriger Betriebsspannung von beispielsweise 24V oder 48V betrieben werden. Diese überträgt die ermittelten, berechneten und/oder bestimmten Daten an die Vektorregelung. Dabei kann die Messvorrichtung Teil der Regelvorrichtung sein oder auch außerhalb der Regelvorrichtung angeordnet sein. Auf jeden Fall handelt es sich um eine Messvorrichtung für einen elektrischen Antrieb zur Bestimmung von Regelparametern einer Vektorregelung, wobei die Messvorrichtung zur Durchführung des Verfahrens nach einem der Ansprüche 1 bis 5 eingerichtet ist.

Die elektrische Maschine wird dabei in d- und q-Achse vermessen. Dazu werden die d-Komponente und die q-Komponente von Statorstrom und/oder Statorspannung gemessen. Zur Anregung der Messung wird ein Stromzeiger in Form eines binären Rauschsignals verwendet. Die Positionierung des Stromzeigers erfolgt mittels entspr. Einstellung des Kommutierungswinkels. Es wird jeweils d-Komponente und q-Komponente des Statorstroms und/oder der Statorspannung gemessen. Um weitere Regelparameter zu erhalten kann auch der Strom in der kurzgeschlossenen Feldwicklung gemessen werden. Nach entsprechender Aufbereitung beispielsweise durch eine Fast Fourier Transformation (FFT) der Daten kann ein einzelner Regelparameter oder Frequenzgänge der Statorimpedanz als Regelparameter berechnet werden. Darüber hinaus kann bei Messung in der d-Achse der Frequenzgang des Verhältnisses von Feld- zu Statorstrom als weiterer Regelparameter berechnet werden.

Dann können diese Frequenzgänge auf Basis der bekannten Ersatzschaltbildern in d- und q-Achse ermittelt und mittels geschickter Wahl von Ersatzschaltbildelementen in Widerstände, Induktivitäten und des Windungszahlenverhältnisses zwischen Feld- und Statorwicklung derart überführt werden, dass sich eine möglichst gute Übereinstimmung herstellen lässt. Dazu können bekannte Interpolationsverfahren verwendet werden. Damit die Messung an definierten Positionen stattfindet, wird in dem ersten Messschritt über ein Minimum im Erregerstrom, die q-Achse detektiert. Der Stromzeiger wird mit einer sehr geringen Frequenz in der Maschine rotiert. Gleichzeitig ist über eine weitere Strommessvorrichtung die Feldwicklung kurzgeschlossen, so dass auch der Feldstrom gemessen werden kann. Das induzierte Signal auf der Feldwicklung erreicht in der q-Achse ein Minimum. Der dazugehörige Transformationswinkel entspricht dann der q-Achse. Der Erregerstrom kann dabei über den Feldstrom oder über den Statorstrom ermittelt werden.

Erfindungsgemäß wird das binäres Rauschsignal durch eine Pseudozufallszahlenfolge mit einem rückgekoppeltem Schieberegister erzeugt, wobei das Schieberegister einen Schiebetakt aufweist, wobei mittels des Schiebetaktes ein vorgebbares Frequenzspektrum erzeugt wird. Durch die Erzeugung des Rauschsignals mittels einem rückgekoppelten Schieberegisters ist auf besonders einfache Weise eine einfache Zuordnung zum Frequenzspektrum möglich. Dieser Stromzeiger ist sowohl auf einfache Weise beispielsweise in einem Stromrichter, der die elektrische Maschine speist, erzeugbar und darüber hinaus sind die Messignale auf einfache Weise in einer Auswertung des Frequenzganges einer entsprechenden Frequenz zuordbar. Der Schiebetakt, mit welchem die Bits durch das Register geschoben werden, ist dabei in vorteilhafter Weise einstellbar. Mit verschiedenen Schiebetakten können dabei entsprechende Spektren erzeugt werden. Zusätzlich wird zu jedem Schiebetakt die Anzahl der Perioden definiert, um die Genauigkeit der Messung und die Dauer der Messung festzulegen. Mit dem Rauschsignal auf Basis der Pseudozufallszahlenfolge kann sowohl die Messung als auch die Auswertung auf einfache Weise in einer Regel- oder Steuereinheit des Stromrichters erfolgen, der die elektrische Maschine speist. Dadurch ist es auch möglich, diese Parameteridentifikation automatisiert auszuführen.

Bei einer weiteren vorteilhaften Ausgestaltung der Erfindung wird die Statorimpedanz in Abhängigkeit von der Frequenz mittels einer Fast Fouriertransformation ermittelt wird. Die Fast Fourier Transformation ist eine einfache numerische Auswertung der Messdaten und erlaubt, nicht nur einen einzelnen frequenzunabhängigen Parameter zu generieren, sondern einen Frequenzgang als Regelparameter. Damit können die Arbeitspunkte und das Verhalten der elektrischen Maschine deutlich genauer beschrieben werden. Dadurch kann die elektrische Maschine deutlich einfacher und genauer geregelt werden. Darüber hinaus können auch kritische Arbeitspunkte, beispielsweise aufgrund von Resonanzen genauer beschrieben werden. Der Regelung ist es dann möglich, auch in diesen Arbeitspunkten ein stabiles Regelverhalten zu erzeugen.

Bei einer weiteren vorteilhaften Ausgestaltung der Erfindung wird der Frequenzgang der Statorimpedanz für den Realteil und den Imaginärteil der Statorimpedanz berechnet. Es hat sich als vorteilhaft erwiesen, den komplexen Wert der Impedanz als Real- und Imaginärteil anzugeben. Dadurch ergibt sich ein pyhsikalischer Bezug zu den Größen des Ersatzschaltbildes. Da dieses oftmals die Grundlage und den physikalischen Bezug zu den Regelgrößen bildet, kann die Regelung dadurch besonders einfach aufgebaut werden. Auch können Fehler in der Parameteridentifikation aufgrund von Plausibilitätskontrollen auf einfache Weise ermittelt werden. Somit ergibt sich durch diese Aufteilung eine besonders robuste und wenig fehleranfällige Regelung.

Bei einer weiteren vorteilhaften Ausgestaltung der Erfindung wird der Feldstrom durch die kurzgeschlossene Feldwicklung gemessen, wobei aus Feldstrom und d-Komponente des Statorstroms das Verhältnis von Feldstrom zu Statorstrom als zweiter Regelparameter bestimmt wird. Auf diese Weise können weitere Regelparameter bestimmt werden, welche es erlauben, das Regelverhalten weiter zu verbessern.

Bei einer weiteren vorteilhaften Ausgestaltung der Erfindung werden die ermittelten, berechneten und/oder bestimmten Regelparameter gespeichert für die Verwendung in der Vektorregelung. Durch die Speicherung kann die Ermittlung der Parameter auch außerhalb der Regelvorrichtung durchgeführt werden. Aber auch wenn diese in der Regelvorrichtung ermittelt werden, kann diese Ermittlung über eigene Softwareroutinen durchgeführt werden. Nach Abschluss dieser Ermittlung werden die Daten gespeichert und für die Regelung des Antriebs, insbesondere für die Vektorregelung, verwendet. Die unterschiedlichen Softwareroutinen wie Ermittlung der Regelparameter und Durchführung der Regelung mittels Vektorregelung können dann unabhängig voneinander durchgeführt werden. Dadurch lässt sich die Struktur der Regelvorrichtung optimieren.

Im Folgenden wird die Erfindung anhand der in den Figuren dargestellten Ausführungsbeispiele näher beschrieben und erläutert. Es zeigen:
- FIG 1: einen elektrischen Antrieb,
- FIG 2: ein Ablaufdiagramm und
- FIG 3: den Frequenzgang einer Statorimpedanz.

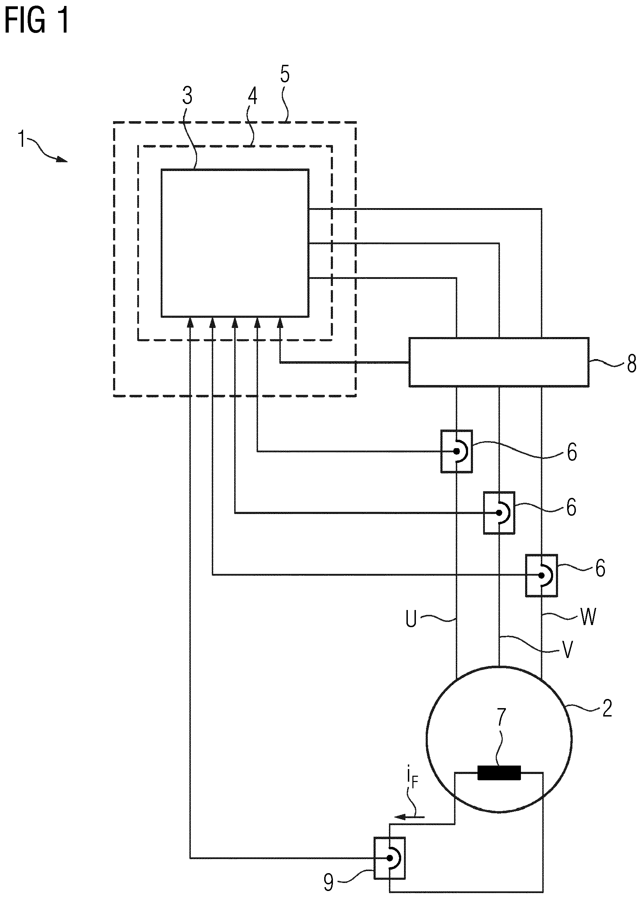

Die FIG 1 zeigt einen elektrischen Antrieb 1 mit einer elektrischen Maschine 2, die über einen Frequenzumrichter 5 mit elektrischer Energie versorgt wird. Der Frequenzumrichter 5 weist dabei eine Regelvorrichtung 4 auf. Diese Regelvorrichtung 4 weist eine Messvorrichtung 3 zur Durchführung des vorgeschlagenen Verfahrens auf. Dabei muss diese Messvorrichtung 3 nicht notwendigerweise Teil des Frequenzumrichters 5 oder Teil der Regelvorrichtung 4 sein. Allerdings bietet es sich an, den Frequenzumrichter 5 als Spannungsquelle für den elektrischen Antrieb 1 zu nutzen, dessen Spannung durch die Messvorrichtung 3 vorgegeben wird. Wicklungsanschlüsse U, V, W sind die Anschlussklemmen der elektrischen Maschine 2. Diese sind mit der Statorwicklung der elektrischen Maschine 2 verbunden. An den Wicklungsanschlüssen U, V, W wird mittels Strommessvorrichtungen 6 der Statorstrom gemessen und mittels einer Spannungsmessvorrichtung 8 die Spannung zwischen den Wicklungsanschlüssen. Dabei ist es hinreichend, nur zwei der drei Spannungen bzw. Ströme zu bestimmen, da sich die dritte Spannung bzw. der dritte Strom aus den beiden anderen mathematisch bestimmen lässt.

Zur Bestimmung der Regelparameter werden die Signale der Strommessvorrichtungen 6 und der Spannungsmessvorrichtung 8 an die Messvorrichtung 3 übertragen.

Darüber hinaus weist die elektrische Maschine 2 noch eine Feldwicklung 7 im Rotor, auch als Rotorwicklung bezeichnet, auf. Mittels einer weiteren Strommessvorrichtung 9 wird die Feldwicklung 7 kurzgeschlossen. Der dabei gemessene Strom kann ebenfalls der Messvorrichtung 3 übermittelt werden. Aus dem Signal der weiteren Strommessvorrichtung 9 kann der Erregerstrom ermittelt werden, mit dem die Ausrichtung der d- und q- Achse erfolgen kann.

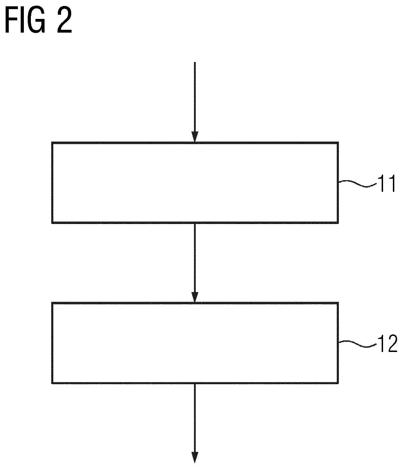

Die FIG 2 zeigt ein Ablaufdiagramm der Parameterbestimmung. In einem ersten Messschritt 11 wird die elektrische Maschine ausgerichtet. Dies bedeutet, dass die Lage der d-Achse und der dazu um 90° versetzten q-Achse bestimmt wird. Dazu wird ein rotierender Stromzeiger in die elektrische Maschine 2 eingespeist, wobei bei einem Minimum des Erregerstroms die q-Achse detektiert wird.

Nachdem die Detektion erfolgreich abgeschlossen wurde, wechselt das Verfahren in den zweiten Messschritt 12. Bei diesem werden die Statorströme und die Statorspannungen gemessen und daraus die Statorimpedanz Zd als erster Regelparameter ermittelt. Diese Messungen kann über ein Frequenzbereich erfolgen, so dass sich die Statorimpedanz als Frequenzgang, also in Abhängigkeit für verschiedene Werte der Frequenz, ergibt.

Ist auch dieser zweite Messschritt abgeschlossen, so kann die Regelvorrichtung mit Hilfe dieser Daten die Vektorregelung ausführen und die elektrische Maschine 2 genau steuern und stabil regeln.

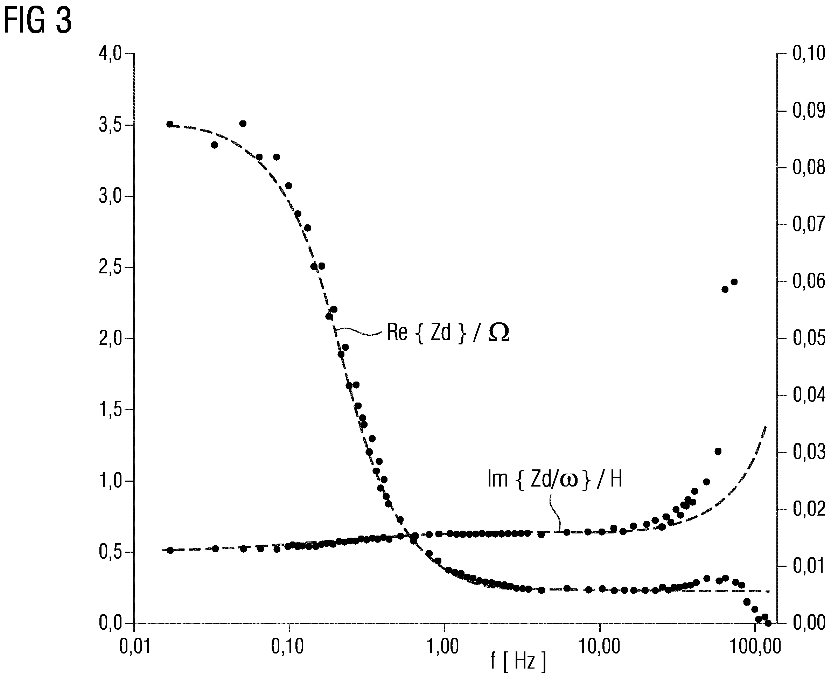

Die FIG 3 zeigt ein typisches Messergebnis der Statorimpedanz, aufgeteilt in Real- und Imaginärteil. Die linke Ordinate gibt dabei die Zahlenwerte für den Realteil an, die rechte Ordinate für den Imaginärteil. Aus diesen Messpunkten kann der Frequenzgang der Statorimpedanz mit bereits bekannten Interpolationsverfahren ermittelt werden.

Zusammenfassend betrifft die Erfindung ein Verfahren zur Bestimmung von Parametern zur Regelung eines elektrischen Antriebs, wobei der elektrische Antrieb mindestens eine elektrische Maschine aufweist. Zur Verbesserung der Inbetriebsetzung des elektrischen Antriebs wird vorgeschlagen, dass an dreiphasigen Wicklungsanschlüssen der elektrischen Maschine als Signal ein Stromzeiger angelegt wird, wobei jeweils eine d-Komponente und eine q-Komponente der Statorspannung und des Statorstroms an den Wicklungsanschlüssen gemessen wird, wobei in einem ersten Messschritt ein rotierender Stromzeiger an die dreiphasigen Wicklungsanschlüsse angelegt wird und die elektrische Maschine derart ausgerichtet wird, dass ein Erregerstrom in der q-Achse ein Minimum annimmt, wobei in einem zweiten Messschritt bei feststehendem Rotor der elektrischen Maschine eine Feldwicklung der elektrischen Maschine kurzgeschlossen und an die Wicklungsanschlüsse ein Stromzeiger in Form eines binären Rauschsignals angelegt wird, wobei aus den Messwerten eine Statorimpedanz als ein erster Regelparameter bestimmt wird. Ferner betrifft die Erfindung eine Regelvorrichtung für einen elektrischen Antrieb, wobei die Regelvorrichtung zur Durchführung eines derartigen Verfahrens eingerichtet ist.

## Patentansprüche

1. Verfahren zur Bestimmung von Regelparametern zur Regelung eines elektrischen Antriebs (1) mittels einer Vektorregelung, wobei der elektrische Antrieb (1) mindestens eine elektrische Maschine (2) aufweist, wobei an dreiphasigen Wicklungsanschlüssen (U,V,W) der elektrischen Maschine (2) als Signal ein Stromzeiger angelegt wird, wobei jeweils eine d-Komponente und eine q-Komponente einer Statorspannung und eines Statorstroms an den Wicklungsanschlüssen (U,V,W) gemessen wird, wobei in einem ersten Messschritt (11) ein rotierender Stromzeiger an die dreiphasigen Wicklungsanschlüssen (U,V,W) angelegt wird und die elektrische Maschine (2) derart ausgerichtet wird, dass ein Erregerstrom in der q-Achse ein Minimum annimmt, wobei in einem zweiten Messschritt bei feststehendem Rotor der elektrischen Maschine (2) eine Feldwicklung (7) der elektrischen Maschine (2) kurzgeschlossen und an die dreiphasigen Wicklungsanschlüsse (U,V,W) ein Stromzeiger in Form eines binären Rauschsignals angelegt wird, wobei aus der gemessenen d-Komponente und der q-Komponente der Statorspannung und des Statorstroms eine Statorimpedanz (Zd) als ein erster Regelparameter bestimmt wird,
**gekennzeichnet dadurch, dass**
das binäres Rauschsignal durch eine Pseudozufallszahlenfolge mit einem rückgekoppeltem Schieberegister erzeugt wird, wobei das Schieberegister einen Schiebetakt aufweist, wobei mittels des Schiebetaktes ein vorgebbares Frequenzspektrum erzeugt wird, wobei mittels verschiedenen Schiebetakten unterschiedliche Frequenzspektrum erzeugt werden.

2. Verfahren nach Anspruch 1, wobei die Statorimpedanz (Zd) in Abhängigkeit von der Frequenz mittels einer Fast Fouriertransformation ermittelt wird.

3. Verfahren nach einem der Ansprüche 1 oder 2, wobei der Frequenzgang der Statorimpedanz (Zd) für den Realteil und den Imaginärteil der Statorimpedanz (Zd) berechnet wird.

4. Verfahren nach einem der Ansprüche 1 bis 3, wobei ein Feldstrom (i_{F}) durch die kurzgeschlossene Feldwicklung (7) gemessen wird, wobei aus Feldstrom (i_{F}) und d-Komponente des Statorstroms das Verhältnis von Feldstrom (i_{F}) zu Statorstrom als zweiter Regelparameter bestimmt wird.

5. Verfahren nach einem der Ansprüche 1 bis 4, wobei die ermittelten, berechneten und/oder bestimmten Regelparameter gespeichert werden für die Verwendung in der Vektorregelung.

6. Regelvorrichtung (4) für einen elektrischen Antrieb (1) zur Durchführung einer Vektorregelung, wobei die Regelvorrichtung (4) zur Durchführung eines Verfahrens nach einem der Ansprüche 1 bis 5 eingerichtet ist, wobei mittels der Regelvorrichtung (4) in einer Inbetriebsetzungsphase mindestens ein Regelparameter für die Vektorregelung bestimmbar und speicherbar ist, wobei nach Abschluss der Inbetriebsetzungsphase mindestens ein gespeicherter Regelparameter für die Vektorregelung verwendbar ist.

7. Elektrischer Antrieb (1), aufweisend
- einen Frequenzumrichter (5) und
- mindestens eine elektrische Maschine (2),
wobei der Frequenzumrichter (5) eine Regelvorrichtung (4) nach Anspruch 6 aufweist, wobei eine Spannungsmessvorrichtung (8) und eine Strommessvorrichtung (6) in der elektrischen Verbindung zwischen Frequenzumrichter (5) und elektrischer Maschine (2) angeordnet sind.

## Claims

1. Method for determining control parameters for controlling an electric drive (1) by means of a vector control, wherein the electric drive (1) has at least one electric machine (2), wherein a current indicator is applied as a signal at three-phase winding connections (U,V,W) of the electric machine (2), wherein in each case a d-component and a q-component of a stator voltage and of a stator current is measured at the winding connections (U,V,W), wherein in a first measurement step (11), a rotating current indicator is applied to the three-phase winding connections (U,V,W) and the electric machine (2) is oriented such that an exciter current in the q-axis assumes a minimum, wherein in a second measurement step, when the rotor of the electric machine (2) is stationary, a field winding (7) of the electric machine (2) is short circuited and a current indicator in the form of a binary noise signal is applied to the three-phase winding connections (U,V,W), wherein a stator impedance (Zd) is determined from the measured d-component and the q-component of the stator voltage and of the stator current as a first control parameter, **characterised in that** the binary noise signal is generated by a pseudo random number sequence with a feedback shift register, wherein the shift register has a shift clock, wherein a predeterminable frequency spectrum is generated by means of the shift clock, wherein different frequency spectra are generated by means of various shift clocks.

2. Method according to claim 1, wherein the stator impedance (Zd) is determined as a function of the frequency by means of a Fast Fourier Transform.

3. Method according to one of claims 1 or 2, wherein the frequency response of the stator impedance (Zd) is calculated for the real part and the imaginary part of the stator impedance (Zd).

4. Method according to one of claims 1 to 3, wherein a field current (i_{F}) is measured by the short-circuited field winding (7), wherein the ratio of the field current (i_{F}) to the stator current is determined as a second control parameter from the field current (i_{F}) and the d-component of the stator current.

5. Method according to one of claims 1 to 4, wherein the ascertained, calculated and/or determined control parameters are stored for use in the vector control.

6. Control apparatus (4) for an electric drive (1) for carrying out a vector control, wherein the control apparatus (4) is configured to carry out a method according to one of claims 1 to 5, wherein at least one control parameter for the vector control can be determined and stored by means of the control apparatus (4) in a start-up phase, wherein at least one stored control parameter can be used for the vector control after completion of the start-up phase.

7. Electric drive (1), having
- a frequency converter (5) and
- at least one electric machine (2),
wherein the frequency converter (5) has a control apparatus (4) according to claim 6, wherein a voltage measuring apparatus (8) and a current measuring apparatus (6) are arranged in the electrical connection between the frequency converter (5) and the electric machine (2).

## Revendications

1. Procédé de détermination de paramètres de régulation pour la régulation d'un entraînement (1) électrique au moyen d'une régulation vectorielle, dans lequel l'entraînement (1) électrique comporte au moins une machine (2) électrique, dans lequel on applique à des bornes (U, V, W) d'enroulement triphasées de la machine (2) électrique, comme signal, un vecteur de courant, dans lequel on mesure respectivement une composante d et une composante q d'une tension statorique et d'un courant statorique aux bornes (U, V, W) de l'enroulement, dans lequel on applique dans un premier stade (11) de mesure, un vecteur tournant aux bornes (U, V, W) de l'enroulement triphasées et on agence la machine (2) électrique, de manière à ce qu'un courant d'excitation dans l'axe q prenne une valeur minimum, dans lequel dans un deuxième stade de mesure, alors que le rotor de la machine (2) électrique est fixe, on court-circuite un enroulement (7) de champ de la machine (2) électrique et on applique aux bornes (U, V, W) de l'enroulement triphasées, un vecteur de courant sous la forme d'un signal de bruit binaire, dans lequel on détermine à partir de la composante d et de la composante q mesurées de la tension statorique et du courant statorique, une impédance (Zd) statorique comme premier paramètre de régulation,
**caractérisé en ce que**
on produit le signal de bruit binaire par une suite de nombres pseudo aléatoire par un registre à décalage à réaction, dans lequel le registre à décalage a une cadence de décalage, dans lequel on produit un spectre de fréquences pouvant être donné à l'avance au moyen de la cadence de décalage, dans lequel on produit des spectres de fréquences différents au moyen de cadences de décalage différentes.

2. Procédé suivant la revendication 1, dans lequel on détermine l'impédance (Zd) statorique en fonction de la fréquence au moyen d'une transformation accélérée de Fourier.

3. Procédé suivant l'une des revendications 1 ou 2, dans lequel on calcule la caractéristique de fréquence de l'impédance (Zd) statorique pour la partie réelle et la partie imaginaire de l'impédance (Zd) statorique.

4. Procédé suivant l'une des revendications 1 à 3, dans lequel on mesure un courant (i_{F}) de champ par l'enroulement (7) de champ court-circuité, dans lequel on détermine, à partir du courant (i_{F}) de champ et de la composante d du courant statorique, le rapport du courant (i_{F}) de champ au courant statorique comme deuxième paramètre de régulation.

5. Procédé suivant l'une des revendications 1 à 4, dans lequel on met en mémoire les paramètres de régulation trouvés, calculés et/ou déterminés, pour les utiliser dans la régulation vectorielle.

6. Système (4) de régulation d'un entraînement (1) électrique pour effectuer une régulation vectorielle, dans lequel le système (4) de régulation est agencé pour effectuer un procédé suivant l'une des revendications 1 à 5, dans lequel, au moyen du système (4) de régulation dans une phase de mise en fonctionnement, au moins un paramètre de régulation pour la régulation vectorielle peut être déterminé et mis en mémoire, dans lequel, après la fin de la phase de mise en fonctionnement, au moins un paramètre de régulation mis en mémoire peut être utilisé pour la régulation vectorielle.

7. Entraînement (1) électrique, comportant :
- un convertisseur (5) de fréquence et
- au moins une machine (2) électrique,
dans lequel le convertisseur (5) de fréquence a un système (4) de régulation suivant la revendication 6, dans lequel un système (8) de mesure de la tension et un système (6) de mesure du courant sont montés dans la connexion électrique entre le convertisseur (5) de fréquence et la machine (2) électrique.
